# EUROPEAN PATENT SPECIFICATION

(11) **EP 3 770 928 B1**
(45) Date of publication and mention of the grant of the patent: **11.10.2023**
(21) Application number: 20187494.8
(22) Date of filing: 23.07.2020
(51) Int. Cl.: H01F 3/10, H01F 27/34, H02M 3/337, H02M 1/44

(54) **COUPLED OUTPUT INDUCTOR AND SYSTEM**
GEKOPPELTER AUSGANGSINDUKTOR UND SYSTEM
INDUCTEUR DE SORTIE ET SYSTÈME COUPLÉS

(30) Priority: 24.07.2019 US 201916521182
(43) Date of publication of application: 27.01.2021
(73) Proprietor: Rockwell Collins, Inc., Cedar Rapids, IA 52498 (US)
(72) Inventor: DEWALD, Justin, Cedar Rapids, IA 52498 (US); LUCAS, Johnny, Cedar Rapids, IA 52498 (US); DEHOTAL, Jarod, Cedar Rapids, IA 52498 (US); WEISS, Jeremy, Cedar Rapids, IA 52498 (US)
(74) Representative: Dehns

(56) References cited:
- EP-A1- 2 299 456
- KR-B1- 100 732 612
- US-A1- 2009 185 398
- US-A1- 2010 254 168
- KEVIN J HARTNETT ET AL: "CCTT-Core Split-Winding Integrated Magnetic for High-Power DC DC Converters", IEEE TRANSACTIONS ON POWER ELECTRONICS, INSTITUTE OF ELECTRICAL AND ELECTRONICS ENGINEERS, USA, vol. 28, no. 11, 1 November 2013 (2013-11-01), pages 4970-4984, XP011507702, ISSN: 0885-8993, DOI: 10.1109/TPEL.2013.2240394
- PENG XU ET AL: "Design of high-input voltage regulator modules with a novel integrated magnetics", APEC 2001. 16TH. ANNUAL IEEE APPLIED POWER ELECTRONICS CONFERENCE AND EXPOSITION. ANAHEIM, CA, MARCH 4 - 8, 2001; [ANNUAL APPLIED POWER ELECTRONICS CONFERENCE], NEW YORK, NY : IEEE, US, vol. 1, 4 March 2001 (2001-03-04), pages 262-267, XP010536005, ISBN: 978-0-7803-6618-3

## Description

### BACKGROUND

A power converter using a current doubler output with a coupled output inductor (as opposed to two independent inductors) can be used to reduce the overall size of the power converter. However, in such an application, the common design for a coupled inductor can result in degraded performance and cause the system to suffer from adverse effects.

Such adverse effects may be present with an existing design of a power converter with a current doubler output that uses a coupled inductor (common magnetic core for multiple inductors) as the output inductor. In such a design, the output inductor is designed to obtain a desired output ripple current by specifying the winding inductance and leakage inductance. In such an existing design, the current ripple can vary significantly, depending on the inductor's proximity to other electrically-conductive non-ferromagnetic materials. For example, an inductor placed very close to an aluminum case could cause the effective leakage inductance to be reduced by 50% or more. This is significant because the current doubler output operates into the leakage inductance of the coupled output inductor and low effective leakage inductance leads to high ripple current. Coupled inductors are disclosed in KR 100732612, EP2299456, US 2009/185398 and US 2010/254168.

Such adverse effects may include significant radiated magnetic field emissions. Radiated emissions from the inductor may also couple into nearby circuitry, causing erroneous behavior or conducted emissions.

### SUMMARY

In one aspect, the invention provides a coupled inductor as defined by claim 1.

**deleted**

**deleted**

### BRIEF DESCRIPTION OF THE DRAWINGS

Implementations of the inventive concepts disclosed herein may be better understood when consideration is given to the following detailed description thereof. Such description makes reference to the included drawings, which are not necessarily to scale, and in which some features may be exaggerated and some features may be omitted or may be represented schematically in the interest of clarity. Like reference numerals in the drawings may represent and refer to the same or similar element, feature, or function. In the drawings:
FIG. 1 is a view of an exemplary embodiment of a system implemented according to the inventive concepts disclosed herein.
FIG. 2A is a view of an exemplary coupled output inductor of FIG. 1 according to the inventive concepts disclosed herein.
FIG. 2B is a view of an exemplary coupled output inductor of FIG. 1 according to the inventive concepts disclosed herein.
FIG. 3 is a view of the coupled output inductor of FIG. 2B according to the inventive concepts disclosed herein.
FIG. 4 is a view of another exemplary coupled output inductor of FIG. 1 according to the inventive concepts disclosed herein.

### DETAILED DESCRIPTION

Before explaining at least one embodiment of the inventive concepts disclosed herein in detail, it is to be understood that the inventive concepts are not limited in their application to the details of construction and the arrangement of the components or steps or methodologies set forth in the following description or illustrated in the drawings. In the following detailed description of embodiments of the instant inventive concepts, numerous specific details are set forth in order to provide a more thorough understanding of the inventive concepts. However, it will be apparent to one of ordinary skill in the art having the benefit of the instant disclosure that the inventive concepts disclosed herein may be practiced without these specific details, within the scope of the claims. In other instances, well-known features may not be described in detail to avoid unnecessarily complicating the instant disclosure. The inventive concepts disclosed herein are capable of other embodiments or of being practiced or carried out in various ways within the scope of the claims. Also, it is to be understood that the phraseology and terminology employed herein is for the purpose of description and should not be regarded as limiting.

As used herein a letter following a reference numeral is intended to reference an embodiment of the feature or element that may be similar, but not necessarily identical, to a previously described element or feature bearing the same reference numeral (e.g., 1, 1a, 1b). Such shorthand notations are used for purposes of convenience only, and should not be construed to limit the inventive concepts disclosed herein in any way unless expressly stated to the contrary.

Further, unless expressly stated to the contrary, "or" refers to an inclusive or and not to an exclusive or. For example, a condition A or B is satisfied by anyone of the following: A is true (or present) and B is false (or not present), A is false (or not present) and B is true (or present), and both A and B are true (or present).

In addition, use of the "a" or "an" are employed to describe elements and components of embodiments of the instant inventive concepts. This is done merely for convenience and to give a general sense of the inventive concepts, and "a" and "an" are intended to include one or at least one and the singular also includes the plural unless it is obvious that it is meant otherwise.

Finally, as used herein any reference to "one embodiment," or "some embodiments" means that a particular element, feature, structure, or characteristic described in connection with the embodiment is included in at least one embodiment of the inventive concepts disclosed herein. The appearances of the phrase "in some embodiments" in various places in the specification are not necessarily all referring to the same embodiment, and embodiments of the inventive concepts disclosed may include one or more of the features expressly described or inherently present herein, or any combination of sub-combination of two or more such features, along with any other features which may not necessarily be expressly described or inherently present in the instant disclosure, provided such embodiments fall within the scope of the claims.

Broadly, embodiments of the inventive concepts disclosed herein are directed to a system to provide a high-permeability path for leakage flux by surrounding a coupled output inductor with high-permeability material (e.g., relative permeability µ/µ₀ much greater than 1, such as greater than 10). Some embodiments may provide a solution to provide immunity to nearby conductive materials and reduce magnetic field emissions while reducing part size, core loss, and resistive losses (DCR).

In some embodiments, a coupled output inductor may provide a high-permeability controlled magnetic path to contain leakage flux from the coupled inductor. The controlled leakage flux path is a part of the ferromagnetic shielding. The coupled output inductor may incorporate a method to control the leakage flux formed at least in part by the shielding and/or ferromagnetic material.

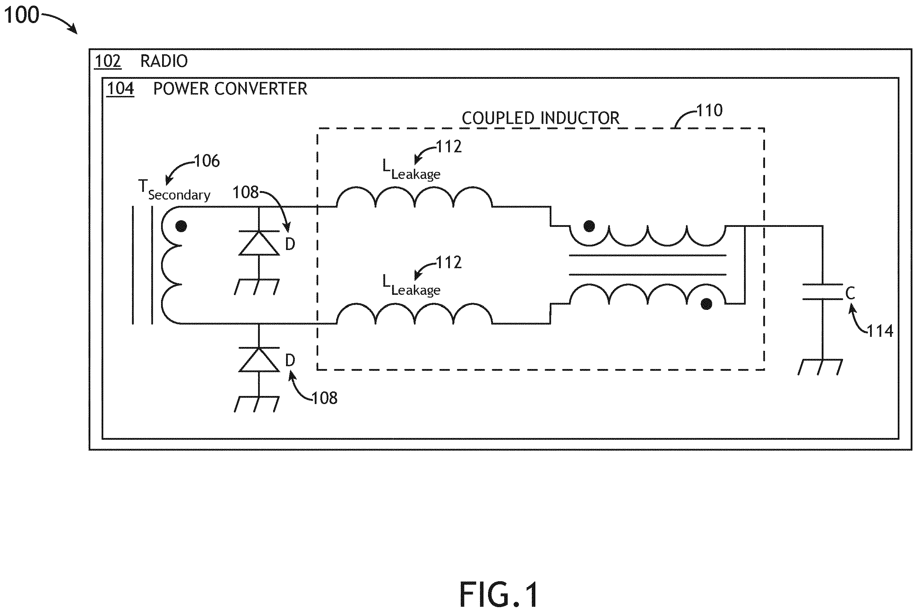

Referring now to FIG. 1, an exemplary embodiment of a system according to the inventive concepts disclosed herein is depicted. For example, the system may be a vehicular system (e.g., an aircraft system) implemented in a vehicle (e.g., an aircraft 100). While FIG. 1 exemplarily depicts an aircraft system implemented on the aircraft 100, some embodiments may be implemented as any suitable vehicular system (e.g., an automobile system, a train system, and/or a ship system) including an electronic device that may include a coupled output inductor implemented in any suitable vehicle (e.g., an automobile, a train, and/or a ship). While FIG. 1 exemplarily depicts a vehicular system, some embodiments may be implemented as a non-vehicular system. For example, some embodiments may be implemented as any suitable system including any suitable electronic device that may include a coupled output inductor.

The aircraft 100 may include at least one electronic device (e.g. radio 102), for example, that may use a power converter 104.

The radio 102 may include at least one power converter 104.

The power converter 104 may be implemented as any suitable power converter, such as a push-pull power converter. The power converter 104 may include at least one power converter transformer 106 (T) (for simplicity, only the secondary side of the power converter's 104 transformer is schematically shown), one or more (e.g., two) rectifying diodes (D) 108, at least one coupled output inductor 110, and output capacitance (C) 114. In some embodiments, the rectifying diodes (D) 108 may be substituted with metal-oxide-semiconductor field-effect transistors (MosFETs) as controlled switches. The power converter 104 may be configured to include a current doubler output by using the coupled output inductor 110. L_{Leakage} represents the leakage inductance 112 of the coupled output inductor 110.

In some embodiments including the coupled output inductor 110, energy is not stored in the portion of the core associated with mutual inductance. The energy is stored in the magnetic field associated with the leakage inductance 112, which is largely in the free space around the core of the coupled output inductor 110.

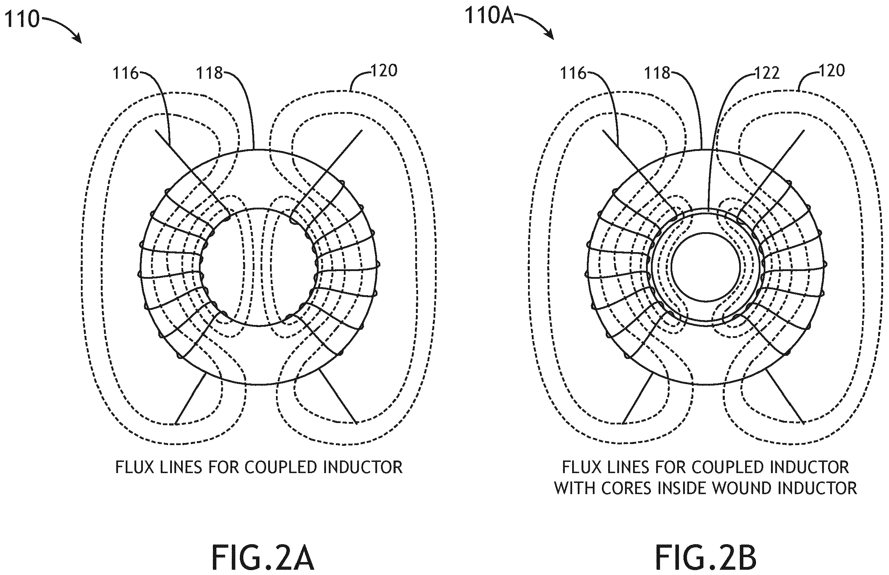

Referring now to FIGS. 2A, 2B, 3, and 4, exemplary embodiments of the coupled output inductor 110, 110A, 110B showing flux lines 120 (e.g., leakage inductance flux lines) according to the inventive concepts disclosed herein are depicted. The coupled output inductor 110, 110A, 110B may include wire 116 (e.g., magnet wire), a ferromagnetic core (e.g., a toroid core 118 (e.g., an outer toroid core) or a ferromagnetic core 118B), shield material (e.g., ferromagnetic material 124, such as ferrite) and, optionally, one or more inner ferromagnetic cores (e.g., inner toroid cores 122). The wire 116 may be wrapped around the ferromagnetic core (e.g., the toroid core 118 (e.g., the outer toroid core) or the ferromagnetic core 118B).

The ferromagnetic core and/or the one or more inner ferromagnetic cores may be composed of high relative permeability material, such as a ferromagnetic material (e.g., ferrite or molypermalloy).

The flux path (e.g., represented by the flux lines 120) generated by the leakage inductance 112 may be largely in free space around the coupled output inductor 110, 110A, 110B. The flux path may interact with nearby electrically-conductive non-ferromagnetic materials, which may attenuate the leakage flux and in turn may reduce the effective leakage inductance 112. The invention includes a shielding (e.g., shield material) including at least one ferromagnetic material 124 (which may have a high relative permeability) around (e.g., surrounding or encasing) the coupled output inductor's 110, 110A, 110B ferromagnetic core 118, 118B and/or the one or more inner ferromagnetic core 122, which may minimize such interaction by containing the flux within the shield material. Furthermore, by containing the flux within the shield material, the magnetic field emissions may also be significantly reduced.

An additional benefit of the shielding is that the shielding may provide a higher permeability path for the flux from the leakage inductance 112 to follow, which may result in overall higher leakage inductance 112.

Furthermore, in some embodiments, with the coupled output inductor 110, 110A having the wire 116 wound on a common toroid core 118, the permeability of the leakage flux path can be further increased by inserting a stack of smaller inner toroid cores 122 inside the outer toroid core 118, such as illustrated in FIG. 2B.

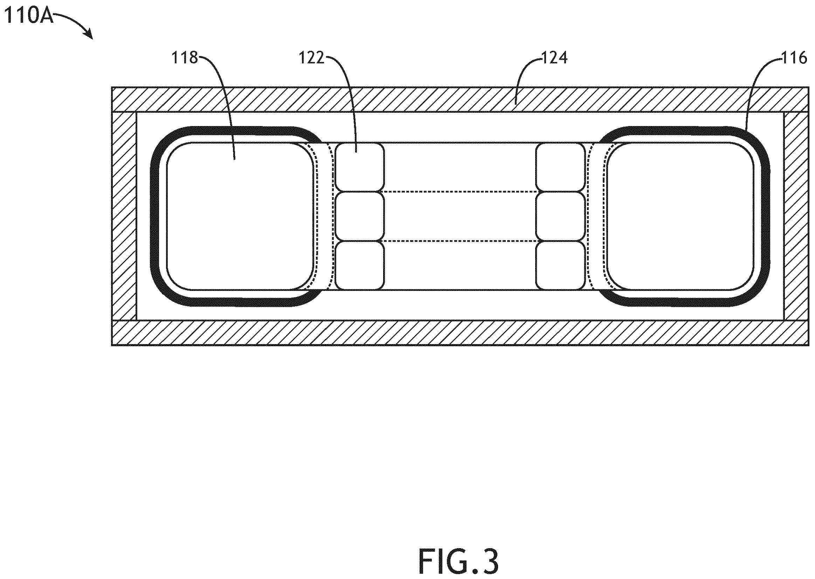

As shown in FIG. 3, which shows a cross-section of the coupled output inductor 110A, in some embodiments, just as the leakage flux may flow through the higher permeability path provided by the inner toroid cores 118, when shielding (e.g., the shield material, i.e. the ferromagnetic material 124, such as ferrite) is added, the leakage flux may be contained within the shielding. In some embodiments, shielding may be similarly applied to the coupled output inductor 110A and 110B.

Some embodiments including the coupled output inductor 110, 110A, 110B may provide immunity to interaction with nearby electrically-conductive non-ferromagnetic material, significantly reduce magnetic field emissions, and may achieve higher inductances with lower losses in a given volume. Such benefits may lead to higher power density solutions.

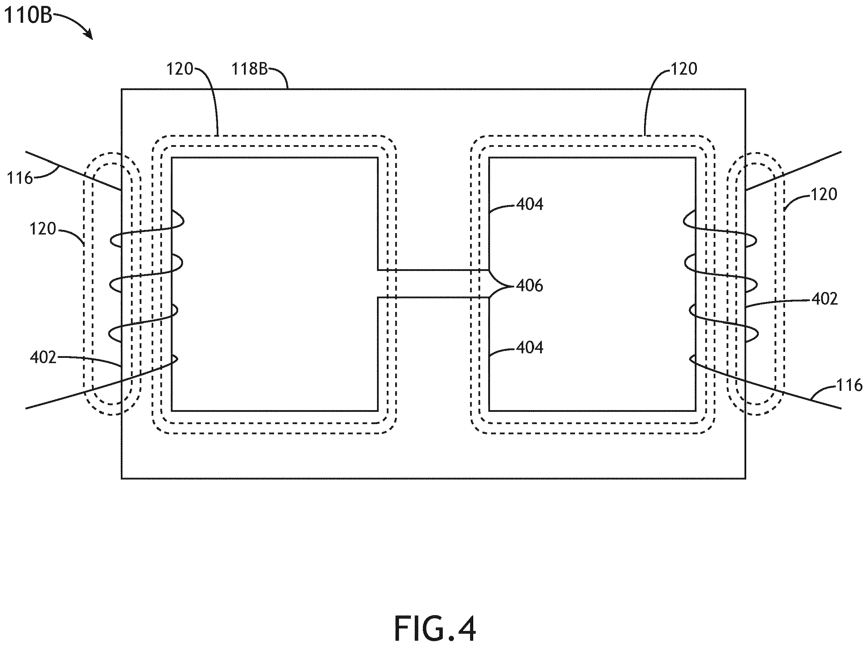

As shown in FIG. 4, an exemplary embodiment of the coupled output inductor 110B showing flux lines 120 according to the inventive concepts disclosed herein is depicted. The coupled output inductor 110B may function similarly to the toroid configuration of FIG. 2B. The coupled output inductor 110B includes wire 116 (e.g., magnet wire), a ferromagnetic core 118B, and shield material (e.g., ferromagnetic material 124, such as ferrite) that surrounds the ferromagnetic core 118B.

In some embodiments, the ferromagnetic core 118B may be generally rectangular, though in other embodiments, the ferromagnetic core may have any suitable shape. In some embodiments, the ferromagnetic core 118B has identical left and right halves (as shown in FIG. 4), though in other embodiments, the ferromagnetic core 118B may be asymmetrical. The ferromagnetic core 118B may include outer portions 402 (e.g., outer legs) where the wire 116 is wound around. The ferromagnetic core 118B may include at least one inner portion 404 (e.g., an inner leg). The inner portion 404 may be gapped with a gap 406 or may be ungapped. The gap 406 or lack of the gap 406 may affect how much leakage flux is allowed to pass through the ferromagnetic core 118B. Some of the flux may pass through a controlled path through the ferromagnetic core 118B and the inner leg, and some of the flux may pass through an uncontrolled path outside of the ferromagnetic core 118B.

Still referring to FIG. 4, the outer two legs may be wound with the wire 116 to form a coupled inductor. The inner leg may provide a path for the leakage flux (similar to the inserted toroid cores 122 in the toroidal configuration of FIG. 2B). If the inner leg is gapped, the leakage flux may be restricted and may in turn provide better coupling between the two windings. If the inner leg is ungapped, the coupling between windings may weaken, but the leakage flux may be mostly (e.g., almost entirely) contained in the inner leg.

In some embodiments, the outer legs may be gapped, which may weaken the coupling between the windings but may also reduce the overall flux induced by the windings. If the outer legs are gapped, most of the flux induced may become leakage flux, but the total leakage flux would may be decreased since the overall flux is reduced.

Some embodiments including the coupled output inductor 110, 110A, 110B may allow products to be driven to smaller form factors with higher power capabilities and lower thermal dissipation, which are goals for power converters utilizing current doubler outputs. Some embodiments including the coupled output inductor 110, 110A, 110B may allow for smaller, lighter, and more efficient power solutions for products, such as small-form factor radios with small-form factor power converters.

As will be appreciated from the above, embodiments of the inventive concepts disclosed herein may be directed to a system, a power converter, and a coupled output inductor configured to provide a high-permeability path for leakage flux by surrounding a coupled output inductor with high relative permeability material.

As used throughout and as would be appreciated by those skilled in the art, "at least one non-transitory computer-readable medium" may refer to as at least one non-transitory computer-readable medium (e.g., at least one computer-readable medium implemented as hardware; e.g., at least one non-transitory processor-readable medium, at least one memory (e.g., at least one nonvolatile memory, at least one volatile memory, or a combination thereof; e.g., at least one random-access memory, at least one flash memory, at least one read-only memory (ROM) (e.g., at least one electrically erasable programmable read-only memory (EEPROM)), at least one on-processor memory (e.g., at least one on-processor cache, at least one on-processor buffer, at least one on-processor flash memory, at least one on-processor EEPROM, or a combination thereof), or a combination thereof), at least one storage device (e.g., at least one hard-disk drive, at least one tape drive, at least one solid-state drive, at least one flash drive, at least one readable and/or writable disk of at least one optical drive configured to read from and/or write to the at least one readable and/or writable disk, or a combination thereof), or a combination thereof).

As used throughout, "at least one" means one or a plurality of; for example, "at least one" may comprise one, two, three, ..., one hundred, or more. Similarly, as used throughout, "one or more" means one or a plurality of; for example, "one or more" may comprise one, two, three, ..., one hundred, or more. Further, as used throughout, "zero or more" means zero, one, or a plurality of; for example, "zero or more" may comprise zero, one, two, three, ..., one hundred, or more.

In the present disclosure, the methods, operations, and/or functionality disclosed may be implemented as sets of instructions or software readable by a device. Further, it is understood that the specific order or hierarchy of steps in the methods, operations, and/or functionality disclosed are examples of exemplary approaches. Based upon design preferences, it is understood that the specific order or hierarchy of steps in the methods, operations, and/or functionality can be rearranged while remaining within the scope of the invention as defined by the claims.

It is to be understood that embodiments of the methods according to the inventive concepts disclosed herein may include one or more of the steps described herein. Further, such steps may be carried out in any desired order and two or more of the steps may be carried out simultaneously with one another. Two or more of the steps disclosed herein may be combined in a single step, and in some embodiments, one or more of the steps may be carried out as two or more sub-steps. Further, other steps or sub-steps may be carried in addition to, or as substitutes to one or more of the steps disclosed herein, within the scope of the claims.

From the above description, it is clear that the inventive concepts disclosed herein are well adapted to carry out the objects and to attain the advantages mentioned herein as well as those inherent in the inventive concepts disclosed herein. While presently preferred embodiments of the inventive concepts disclosed herein have been described for purposes of this disclosure, it will be understood that numerous changes may be made which will readily suggest themselves to those skilled in the art and which are accomplished within the scope of the invention as defined by the claims.

## Claims

1. A coupled output inductor for a current doubler output of a power converter, comprising:
a ferromagnetic core (118); and
wire (116) wrapped around the ferromagnetic core; and further comprising
at least one ferromagnetic path for control of leakage flux,
wherein the leakage flux is at least mostly contained within the at least one ferromagnetic path; and **characterised in that** the at least one ferromagnetic path comprises a shielding surrounding the ferromagnetic core and the wire, wherein the shielding is composed of a ferromagnetic material (124).

2. The coupled output inductor of claim 1, wherein the ferromagnetic core is at least composed of at least one of ferrite or molypermalloy.

3. The coupled output inductor of claim 1 or 2, wherein the shielding is at least composed of ferrite, and/or
wherein the shielding reduces magnetic field emissions as compared to a coupled output inductor without the shielding, and/or
wherein the shielding provides a path for the leakage flux to flow, which results in overall higher leakage inductance as compared to a coupled output inductor without the shielding.

4. The coupled output inductor of any preceding claim, wherein the ferromagnetic core is a toroid core.

5. The coupled output inductor of any preceding claim, wherein the ferromagnetic core includes outer legs (402) and an inner leg (404), wherein the wire is wrapped around the outer legs of the ferromagnetic core, wherein the at least one ferromagnetic path further comprises the inner leg.

6. The coupled output inductor of claim 5, wherein the inner leg is gapped (406)

7. A system, comprising:
a coupled output inductor (110) according to any preceding claim

8. The system of claim 7, further comprising a power converter (104), wherein the power converter comprises the coupled output inductor (110).

9. The system of claim 8, further comprising an electronic device comprising the power converter.

10. The system of claim 8 or 9, wherein the power converter is implemented in a vehicle (100).

11. The system of claim 8, 9 or 10, wherein the power converter further comprises at least one transformer (106) and at least one rectifying diode (108), the at least one transformer coupled to the at least one rectifying diode, the at least one rectifying diode coupled to the coupled output inductor (110).

12. The system of claims 8 to 11, wherein the power converter includes a current doubler output comprising the coupled output inductor.

## Patentansprüche

1. Gekoppelter Ausgangsinduktor für einen Stromverdopplerausgang eines Leistungswandlers, umfassend:
einen ferromagnetischen Kern (118); und
Draht (116), der um den ferromagnetischen Kern herumgewickelt ist; und ferner umfassend
mindestens einen ferromagnetischen Pfad zur Steuerung von Streufluss,
wobei der Streufluss mindestens größtenteils innerhalb des mindestens einen ferromagnetischen Pfads enthalten ist; und **dadurch gekennzeichnet, dass** der mindestens eine ferromagnetische Pfad eine Abschirmung umfasst, die den ferromagnetischen Kern und den Draht umgibt, wobei die Abschirmung aus einem ferromagnetischen Material (124) zusammengesetzt ist.

2. Gekoppelter Ausgangsinduktor nach Anspruch 1, wobei der ferromagnetische Kern mindestens aus einem von Ferrit oder Molypermalloy zusammengesetzt ist.

3. Gekoppelter Ausgangsinduktor nach Anspruch 1 oder 2, wobei die Abschirmung mindestens aus Ferrit zusammengesetzt ist, und/oder wobei die Abschirmung Magnetfeldemissionen im Vergleich zu einem gekoppelten Ausgangsinduktor ohne die Abschirmung reduziert, und/oder
wobei die Abschirmung einen Pfad für den Streufluss zum Fließen bereitstellt, was in einer insgesamt höheren Streuinduktivität im Vergleich zu einem gekoppelten Ausgangsinduktor ohne die Abschirmung resultiert.

4. Gekoppelter Ausgangsinduktor nach einem der vorhergehenden Ansprüche, wobei der ferromagnetische Kern ein Ringkern ist.

5. Gekoppelter Ausgangsinduktor nach einem der vorhergehenden Ansprüche, wobei der ferromagnetische Kern äußere Schenkel (402) und einen inneren Schenkel (404) beinhaltet, wobei der Draht um die äußeren Schenkel des ferromagnetischen Kerns herumgewickelt ist, wobei der mindestens eine ferromagnetische Pfad ferner den inneren Schenkel umfasst.

6. Gekoppelter Ausgangsinduktor nach Anspruch 5, wobei der innere Schenkel einen Spalt (406) aufweist.

7. System, umfassend:
einen gekoppelten Ausgangsinduktor (110) nach einem der vorhergehenden Ansprüche.

8. System nach Anspruch 7, ferner umfassend einen Leistungswandler (104), wobei der Leistungswandler den gekoppelten Ausgangsinduktor (110) umfasst.

9. System nach Anspruch 8, ferner umfassend eine elektronische Vorrichtung, die den Leistungswandler umfasst.

10. System nach Anspruch 8 oder 9, wobei der Leistungswandler in einem Fahrzeug (100) implementiert ist.

11. System nach Anspruch 8, 9 oder 10, wobei der Leistungswandler ferner mindestens einen Transformator (106) und mindestens eine Gleichrichterdiode (108) umfasst, wobei der mindestens eine Transformator an die mindestens eine Gleichrichterdiode gekoppelt ist, wobei die mindestens eine Gleichrichterdiode an den gekoppelten Ausgangsinduktor (110) gekoppelt ist.

12. System nach den Ansprüchen 8 bis 11, wobei der Leistungswandler einen Stromverdopplerausgang beinhaltet, der den gekoppelten Ausgangsinduktor umfasst.

## Revendications

1. Inducteur de sortie couplée pour une sortie doubleuse de courant d'un convertisseur de puissance, comprenant :
un noyau ferromagnétique (118) ; et
un câble (116) enroulé autour du noyau ferromagnétique ; et comprenant en outre
au moins un chemin ferromagnétique pour une régulation d'écoulement de fuite,
dans lequel l'écoulement de fuite est au moins majoritairement contenu dans l'au moins un trajet ferromagnétique ; et **caractérisé en ce que** l'au moins un chemin ferromagnétique comprend un blindage entourant le noyau ferromagnétique et le câble, dans lequel le blindage est composé d'un matériau ferromagnétique (124).

2. Inducteur de sortie couplée selon la revendication 1, dans lequel le noyau ferromagnétique est au moins composé d'au moins un élément parmi la ferrite ou le molypermalloy.

3. Inducteur de sortie couplée selon la revendication 1 ou 2, dans lequel le blindage est au moins composé de ferrite, et/ou dans lequel le blindage réduit des émissions de champ magnétique par rapport à un inducteur de sortie couplée sans le blindage, et/ou
dans lequel le blindage fournit un chemin pour que l'écoulement de fuite s'écoule, ce qui entraîne une inductance de fuite globalement plus élevée par rapport à un inducteur de sortie couplée sans le blindage.

4. Inducteur de sortie couplée selon une quelconque revendication précédente, dans lequel le noyau ferromagnétique est un noyau toroïdal.

5. Inducteur de sortie couplée selon une quelconque revendication précédente, dans lequel le noyau ferromagnétique comporte des branches externes (402) et une branche interne (404), dans lequel le câble est enroulé autour des branches externes du noyau ferromagnétique, dans lequel au moins un chemin ferromagnétique comprend en outre la branche intérieure.

6. Inducteur de sortie couplée selon la revendication 5, dans lequel la branche interne est écartée (406).

7. Système, comprenant :
un inducteur de sortie couplée (110) selon une quelconque revendication précédente.

8. Système selon la revendication 7, comprenant en outre un convertisseur de puissance (104), dans lequel le convertisseur de puissance comprend l'inducteur de sortie couplée (110).

9. Système selon la revendication 8, comprenant en outre un dispositif électronique comprenant le convertisseur de puissance.

10. Système selon la revendication 8 ou 9, dans lequel le convertisseur de puissance est mis en œuvre dans un véhicule (100) .

11. Système selon la revendication 8, 9 ou 10, dans lequel le convertisseur de puissance comprend en outre au moins un transformateur (106) et au moins une diode de redressement (108), l'au moins un transformateur couplé à l'au moins une diode de redressement, l'au moins une diode de redressement couplée à l'inducteur de sortie couplée (110).

12. Système selon les revendications 8 à 11, dans lequel le convertisseur de puissance comporte une sortie doubleuse de courant comprenant l'inducteur de sortie couplée.
